# EUROPÄISCHE PATENTSCHRIFT

(11) **EP 2 652 777 B1**
(45) Veröffentlichungstag und Bekanntmachung des Hinweises auf die Patenterteilung: **10.12.2014**
(21) Anmeldenummer: 11808556.2
(22) Anmeldetag: 12.12.2011
(51) Int. Cl.: H01L 21/67, C25D 7/12, H01L 21/288

(54) **VORRICHTUNG UND VERFAHREN ZUM METALLISIEREN VON WAFERN**
APPARATUS AND METHOD TO METALLIZE WAFERS
APPAREIL ET PROCEDE POUR METALLISER DES PLAQUETTES

(30) Priorität: 15.12.2010 AT 20752010
(43) Veröffentlichungstag der Anmeldung: 23.10.2013
(73) Patentinhaber: Hacksteiner, Markus, 9500 Villach (AT)
(72) Erfinder: Hacksteiner, Markus, 9500 Villach (AT)
(74) Vertreter: Beer & Partner Patentanwälte KG
(86) Internationale Anmeldenummer: PCT/AT2011/000492
(87) Internationale Veröffentlichungsnummer: WO 2012/079101

(56) Entgegenhaltungen:
- EP-A2- 1 067 221
- EP-A2- 1 441 048
- US-A1- 2004 055 890
- US-A1- 2007 289 873

## Beschreibung

Die Erfindung betrifft eine Vorrichtung zum Metallisieren von Wafern mit den Merkmalen des einleitenden Teils von Anspruch 1 (EP 1 441 048 A2). Die Erfindung betrifft weiters Verfahren zum Metallisieren von Wafern.

Im Stand der Technik ist das elektrolytische Metallisieren von Wafern, insbesondere Mikrochipwafern (z.B. mit Kupfer), bekannt. Das bekannte Metallisieren erfolgt im Einzelwafer-Modus, was bedeutet, dass je Verfahren und Prozesskammer ein einziger Wafer prozessiert, d.h. metallisiert wird. Üblicherweise wird der zu metallisierende Wafer (z.B. ein Mikrochipwafer) mit seiner Vorderseite nach unten in einen Elektrolyt eingetaucht. Während des Prozesses (Metallisieren) wird ständig Elektrolyt laminar und parallel zur Waferoberfläche in Strömung versetzt. Um diesen Strömungszustand einzustellen und aufrecht zu halten, ist erhöhte Aufmerksamkeit geboten und es sind aufwändige Vorrichtungen nötig.

Ein Nachteil der bekannten Verfahrensweise ist es, dass das Metallisieren wegen langer Prozesszeiten (viele Minuten bis Stunden) sehr teuer ist, da nur jeweils ein Wafer je Prozess und Prozesskammer gefahren werden kann. Je größer die Strukturen auf der Oberfläche des Mikrochipwafers sind, die mit Metall gefüllt werden müssen, um so länger sind die Prozesszeiten.

Im Hinblick darauf, dass zu erwarten ist, dass Mikrochips zunehmend vertikal integriert werden (mehrere Mikrochiplagen übereinander, die zueinander kontaktiert werden müssen), ist das Befüllen von breiten und tiefen Kanälen (sogenannten Through Silicon Vias), welche im fertigen Mikrochip als vertikale Leiterbahnen dienen, mit einem elektrisch leitenden Metall, z.B. Kupfer, erforderlich. Diese Kanäle können Breiten von etlichen Mikrometern und Tiefen bis zu 100 Mikrometern und mehr aufweisen.

Aus der EP 1 441 048 A2 ist eine gattungsgemäße Vorrichtung zum Plattieren von Wafern bekannt. Die Einrichtung umfasst ein Gefäß mit einer Seitenwand, in welche aus einer Sprühdüse Elektrolyt eingesprüht wird. Oberhalb des Gefäßes wird ein Wafer von einer drehbaren Halteeinrichtung in Drehung versetzt, sodass Elektrolyt, der über die Oberfläche geflossen ist, seitlich abgezogen wird. Die Strömung des Elektrolyt entlang des Wafers kann durch eine Luftabzugseinrichtung ergänzt werden.

Vorrichtungen zum Metallisieren von Wafern sind auch aus den Dokumenten EP 1 067 221 A2, US 2007/0289873 A und US 2004/0055890 A1 bekannt.

Der Erfindung liegt die Aufgabe zu Grunde, eine Vorrichtung der eingangs genannten Gattung zur Verfügung zu stellen, mit der das Metallisieren von Wafern, insbesondere Mikrochipwafern, im Batchbetrieb bei gutem Erfolg möglich ist.

Gelöst wird diese Aufgabe mit einer Vorrichtung, welche die Merkmale von Anspruch 1 aufweist.

Bevorzugte und vorteilhafte Ausgestaltungen der erfindungsgemäßen Vorrichtungen sind Gegenstand der Unteransprüche.

Ein Vorteil der erfindungsgemäßen Vorrichtung ist der geringe Raumbedarf pro zu metallisierenden Wafer, insbesondere Mikrochipwafer. So ist je Wafer nur wenig Elektrolyt er-forderlich, was insbesondere dann der Fall ist, wenn mit der erfindungsgemäßen Vorrichtung für jeden Wafer ein abgeschlossenes Elektrolytvolumen vorliegt.

Die erfindungsgemäße Vorrichtung, die wenigstens eine, vorzugsweise aber mehrere Halteeinrichtungen für das gleichzeitige Metallisieren mehrerer Wafer (Mikrochipwafer) aufweist, kann "als "geöffneter Batch", also mit offenem Elektrolyt-Raum, in ein Elektrolysebad mit nach oben weisender Wafervorderseite eingetaucht werden und danach wird sie wenigstens teilweise zusammengefahren (um Raum zu sparen) oder aber die Halteeinrichtungen werden ganz geschlossen ("geschlossener Batch").

Bei der erfindungsgemäßen Vorrichtung ist es auch möglich, die Halteeinrichtungen für die einzelnen Wafer von vorne herein zu schließen und jeden der in den Halteeinrichtungen vorgesehenen Räume für Elektrolyt über Zuleitungen und Ableitungen mit Elektrolyt zu füllen.

Wenn die erfindungsgemäße Vorrichtung als "geschlossener Batch" eingesetzt wird, wird der Raum, der je Wafer für den Elektrolyt zur Verfügung steht, durch den Wafer, den Rahmen und die obere Abschlussplatte, die gegebenenfalls eine Basisplatte einer weiteren Halteeinrichtung ist, definiert.

Im Rahmen der Erfindung kann vorgesehen sein, dass die erfindungsgemäße Vorrichtung mit Hilfe eines Exzenters in Schwingungen versetzt wird, so dass sich ein schwingender Elektrolytkörper ergibt. Die Frequenz kann fix oder gewählt-variabel oder zufällig-variabel eingestellt werden.

Wenn die erfindungsgemäße Vorrichtung mit nach oben weisender Wafervorderseite in ein Elektrolysebad eingetaucht wird, ist bevorzugt, dass die einzelnen Halteeinrichtungen noch nicht zusammengeschoben sind, damit der Elektrolyt aus dem Bad zwischen die Halteeinrichtungen strömen und Gas entweichen kann. Sobald die erfindungsgemäße Vorrichtung im Elektrolyt positioniert ist, können die Halteeinrichtungen für die Wafer teilweise oder ganz zusammengeschoben werden, wenn ein "geschlossener Batch" verwendet wird.

Wenn bei der erfindungsgemäßen Vorrichtung mit "geschlossenem Batch" gearbeitet wird, ergibt sich auf Grund des abgeschlossenen Elektrolytkörpers eine Abreicherung von Metallionen während des Metallisierungsprozesses. Dies kann durch eine entsprechende Prozesssteuerung ausgeglichen werden.

Die erfindungsgemäße Vorrichtung erlaubt eine Verfahrensführung, die ein elektrolytisches Metallisieren von großen Mikrochipstrukturen im Batchbetrieb bei minimalem Raumbedarf ermöglicht. So können Kosten eingespart werden.

Weitere Einzelheiten und Merkmale der Erfindung ergeben sich aus der nachfolgenden Beschreibung eines bevorzugten Ausführungsbeispieles.

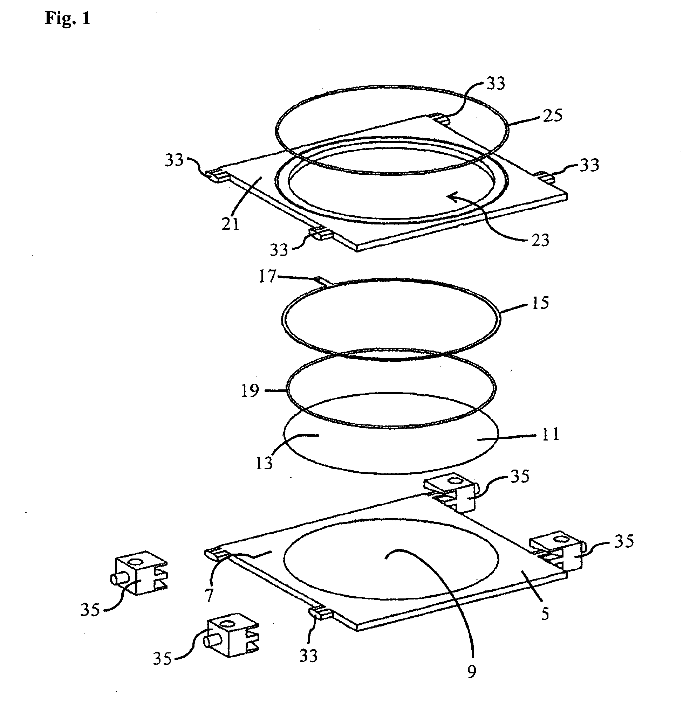

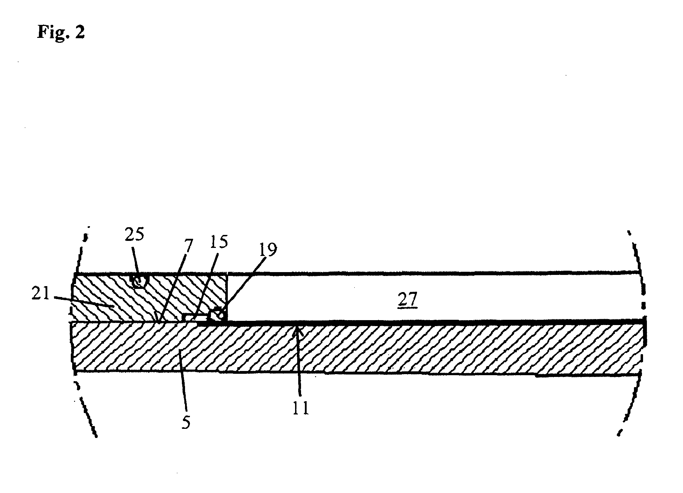

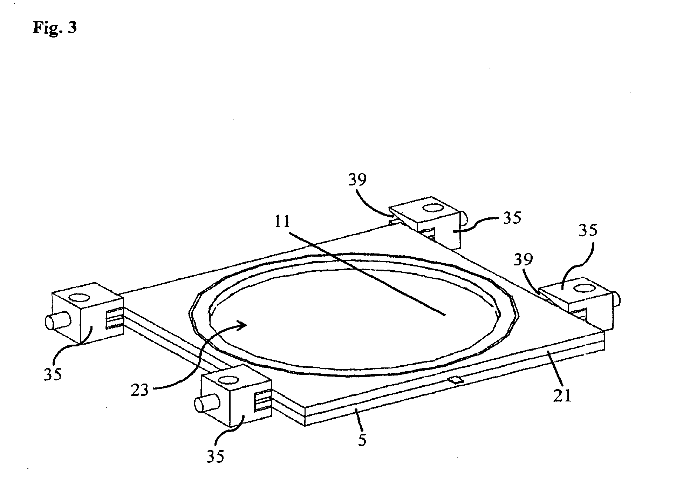

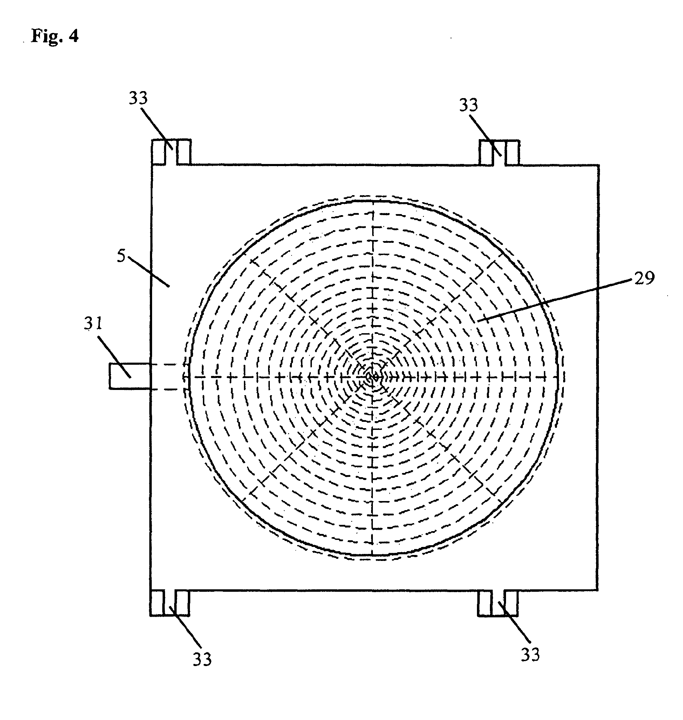

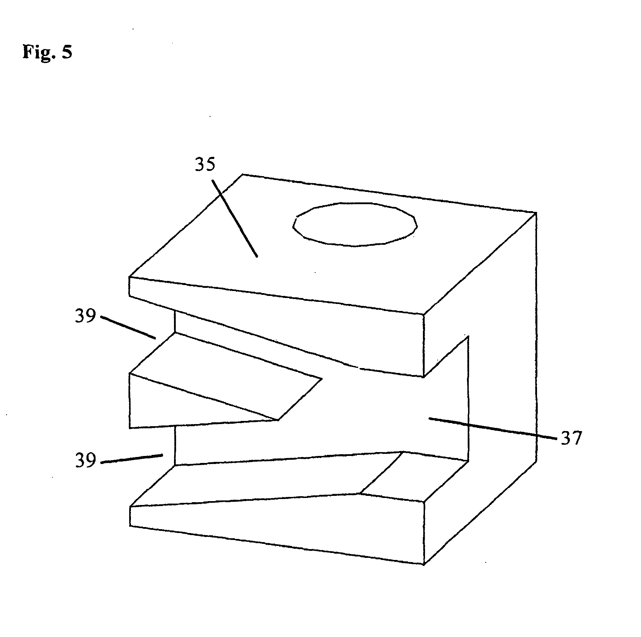

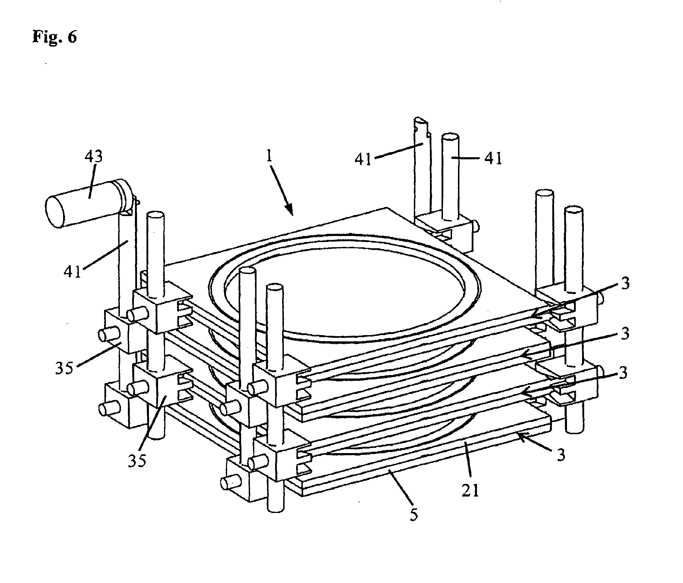

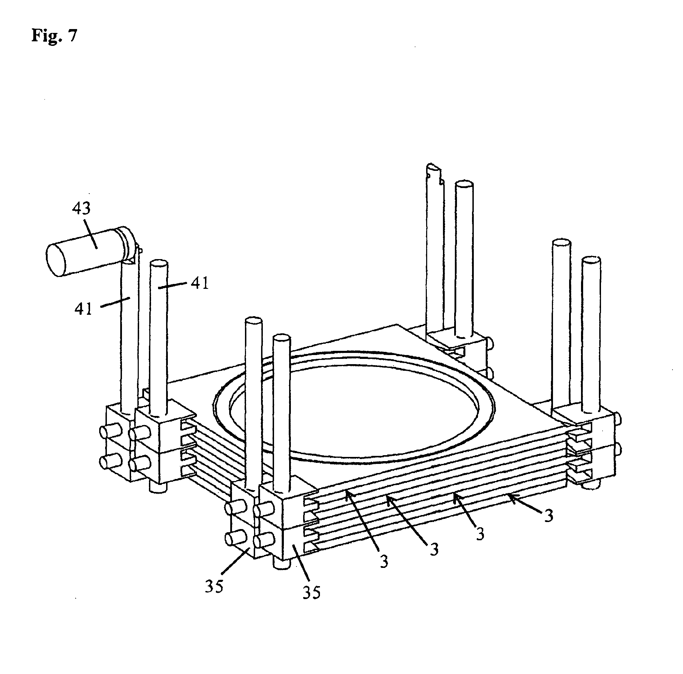

Es zeigt: Fig. 1 in auseinandergezogener Darstellung eine Halteeinrichtung einer erfindungsgemäßen Vorrichtung, Fig. 2 im Schnitt einen Teil der Halteeinrichtung, Fig. 3 eine Halteeinrichtung (ohne obere Abschlussplatte) in Schrägansicht, Fig. 4 eine Basisplatte mit Anodennetz von unten her gesehen, Fig. 5 einen Klemmkörper in Schrägansicht, Fig. 6 eine erfindungsgemäße Vorrichtung mit mehreren Halteeinrichtungen "geöffnet" und Fig. 7 die Vorrichtung aus Fig. 6 mit geschlossenen Halteeinrichtungen.

Eine erfindungsgemäße Vorrichtung 1 weist eine oder mehrere, im in den Zeichnungen gezeigten Ausführungsbeispiel vier, Halteeinrichtungen 3 auf.

Jede der Halteeinrichtungen 3 weist, wie insbesondere die Fig. 1 und 2 zeigen, die folgenden Teile auf:
Eine Basisplatte 5 aus elektrisch isolierendem Werkstoff, an deren Oberseite 7 eine kreisförmige Vertiefung 9 (Aussparung) vorgesehen ist, in der ein zu behandelnder Wafer 11, insbesondere ein Mikrochipwafer, eingelegt werden kann, wobei dessen Vorderseite 13, also die Seite, an der die durch elektrolytisches Metallisieren in einem Elektrolyten mit Metall, beispielsweise Kupfer, zu füllenden Kanäle vorliegen, nach oben weist.

Auf den Randbereich des Wafers 11 wird ein als Kathode dienender Ring 15 aus elektrisch leitendem Werkstoff aufgelegt, der über eine Fahne 17 an eine Spannungsquelle angeschlossenen werden kann, um den Wafer 11 als Kathode zu polen. Innerhalb des Ringes 15, der als Kathode dient, um den Wafer 11 im Sinne der Polung als Kathode mit dem Minus-Pol einer Spannungsquelle zu verbinden, ist eine ringförmige Dichtung 19, insbesondere ein O-Ring, eingelegt.

Oberhalb der beschriebenen Anordnung aus Basisplatte 5, Wafer 11, Ring 15 (Kathode) und Dichtungsring 19 wird ein Rahmen 21 aus elektrisch isolierendem Werkstoff aufgelegt, in dem eine Aussparung 23, die den Raum 27 für Elektrolyt seitlich begrenzt, vorgesehen ist. Der Rahmen 21 hat beispielsweise eine Höhe von nicht mehr als 20 mm.

Auf den Rahmen 21 aus isolierendem Werkstoff mit seiner Aussparung 23 wird rings um die Aussparung 23 eine ringförmige Dichtung 25, beispielsweise ein O-Ring aufgelegt. Die Dichtung 25 kann auch in einer ringförmigen Nut im Rahmen 21 aufgenommen sein (vgl. Fig. 2).

Um die Halteeinrichtung 3 zu vervollständigen, wird auf die Dichtung 25 auf dem Rahmen 21 eine obere Abschlussplatte, die gegebenenfalls eine Basisplatte 5 einer weiteren Halteeinrichtung 3 ist, aufgelegt.

Wie Fig. 2 zeigt, wird durch den Rahmen 21, durch den Wafer 11 sowie durch die obere Abschlussplatte, die insbesondere die Basisplatte 5 einer weiteren Halteeinrichtung 3 sein kann, der Raum 27 definiert, der für das elektrolytische Metallisieren des Wafers 11 mit Elektrolyt gefüllt wird.

Der Halteeinrichtung 3 kann (nicht gezeigt) eine Einrichtung zum Erwärmen/Kühlen zugeordnet sein, um die Halteeinrichtung 3 auf der jeweils erforderlichen Temperatur zu halten (zu temperieren).

Im gezeigten Ausführungsbeispiel (vgl. Fig. 2) ist vorgesehen, dass die obere Abschlussplatte, welche die Basisplatte 5 einer weiteren Halteeinrichtung 3 sein kann, an ihrer Unterseite ein Anodennetz 29 trägt (vgl. Fig. 4), das mit einer Fahne 31 ausgestattet ist, um das Anodennetz 29 an der Unterseite der Abschlussplatte (Basisplatte 5) mit dem Plus-Pol einer Spannungsquelle verbinden zu können.

Um den Spannungsabfall vom Außenrand des Wafers 11 zur Mitte des Wafers 11 auszugleichen, kann die Unterseite der Basisplatte 5 mit dem Anodennetz 29 konvex sein. Zusätzlich oder alternativ kann die Dichte der das Anodennetz 29 bildenden Leiter zur Mitte des Anodennetzes 29 hin zunehmen. Das Anodennetz 29 ist also zur Mitte hin dichter gewebt.

Im gezeigten Ausführungsbeispiel ist in Betracht gezogen, in der erfindungsgemäßen Vorrichtung 1 übereinander mehrere Halteeinrichtungen 3 vorzusehen. Daher ist es bevorzugt, wenn die obere Abschlussplatte von Halteeinrichtungen 3 von der Basisplatte 5 (mit Anodennetz 29) der nächst oberen Halteeinrichtung 3 gebildet ist, wie dies in dem in den Zeichnungen (Fig. 6 und 7) gezeigten Ausführungsbeispiel der Fall ist.

Um die Basisplatte 5 ("Anodenplatte") mit dem Rahmen 21 ("Kathodenrahmen"), die beide aus isolierendem Werkstoff bestehen, aneinander zu drücken, um sie miteinander flüssigkeitsdicht zu verbinden, sind an den seitlichen Rändern der Basisplatte 5 und des Rahmens 21 nach außen weisende Vorsprünge 33 (Zungen), die sich nach beiden Seiten keilförmig verjüngen, vorgesehen, denen Klemmkörper 35 zugeordnet sind. Die Klemmkörper 35 haben auf ihrer der Basisplatte 5 und dem Rahmen 21 zugekehrten Seite eine Nut 37, die sich Y-förmig in zwei Äste 39 gabelt (vgl. Fig. 5).

In der geöffneten Stellung sind die Zungen 33 der Basisplatte 5 und des Rahmens 21 in den Ästen 39 der Nut 37 vorgesehen, so dass die Basisplatte 5 vom Rahmen 21 beabstandet ist. Durch Verschieben der Klemmkörper 35 in einer zur Ebene der Basisplatte 5 und des Rahmens 21 parallelen Ebene können die genannten Bestandteile (Basisplatte 5 und Rahmen 21) der erfindungsgemäßen Halteeinrichtung 3 aneinander gedrückt werden. Diese Gebrauchslage von Basisplatte 5 und Rahmen 21 der Halteeinrichtung 3 ist in Fig. 2 und in Fig. 3 gezeigt. Die Vorrichtungen, mit denen die Klemmkörper 35 entlang der Führungsstäbe 41 verstellt, d.h. einander angenähert werden, um die einzelnen Halteeinrichtungen 3 zusammenzufahren, sind nicht dargestellt.

Fig. 5 zeigt einen Klemmkörper 35 in vergrößertem Maßstab und die Nut 37, die sich Y-förmig in zwei Äste 39 teilt.

In Fig. 6 ist eine erfindungsgemäße Vorrichtung 1 mit mehreren Halteeinrichtungen 3 in geöffnetem Zustand ("geöffneter Batch"), jedoch ohne "obere" Abschlussplatte auf der obersten Halteeinrichtung 3, gezeigt. Die Klemmkörper 35 sind auf zur Ebene der Halteeinrichtungen 3 senkrecht ausgerichtete Führungsstäben 41 verstellbar geführt, wobei die Führungsstäbe 41 durch nicht gezeigte Stellmittel quer zu ihrer Längserstreckung, d.h. in eine Richtung parallel zur Ebene der Halteeinrichtungen 3, verstellt werden können, um die jeweiligen Halteeinrichtungen 3 über die Klemmkörper 35 zu öffnen oder zu schließen.

In jede Halteeinrichtung 3 wird zwischen Basisplatte 5 und Rahmen 21 ein zu behandelnder (metallisierender) Wafer 11 (Mikrochipwafer) beispielsweise mit Hilfe einer für Wafer 11 üblichen Handhabungsvorrichtung (Greifer) so eingelegt, dass er in der Aufnahme 9 in der unteren Basisplatte 5 (Anodenplatte) mit seiner Vorderseite nach oben zu liegen kommt. Grundsätzlich ist es möglich, das Metallisieren auszuführen, wenn die Vorrichtung 1 eine Stellung ("geöffneter Batch") gemäß Fig. 6 einnimmt, wobei ein gemeinsamer Elektrolyt für das Behandeln aller in den einzelnen Halteeinrichtungen 3 vorgesehen Wafer 11 vorgesehen ist.

Fig. 6 und 7 zeigen auch, dass die Zungen 33 sowie die Klemmkörper 35 aufeinanderfolgender (benachbarter) Halteeinrichtungen 3 zueinander versetzt angeordnet sind, damit die Halteeinrichtungen 3 aus der in Fig. 6 gezeigten, voneinander beabstandeten Lage (geöffneter Batch) in die in Fig. 7 gezeigte aneinander anliegende Lage (geschlossener Batch) verstellt werden können, ohne dass die Klemmkörper 35 diese Bewegung behindern oder verhindern.

Mit Vorteil ist im Rahmen der Erfindung vorgesehen, dass die Halteeinrichtungen 3 der erfindungsgemäßen Vorrichtung 1, wie dies in Fig. 7 gezeigt ist, durch Verstellen der Klemmkörper 35 entlang der Führungsstäbe 41 einander angenähert werden, so dass der Rahmen 21 jeder Halteeinrichtung 3 mit der Basisplatte 5 der nächst oberen Halteeinrichtung 3 in Anlage kommt (abgedichtet durch den Dichtungsring 25). So bilden die Basisplatten 5 der jeweils oberen Halteeinrichtung 3 gleichzeitig die Abschlussplatte der nächst unteren Halteeinrichtung 3 ("geschlossener Batch"). In diesem Fall ist in jeder Halteeinrichtung 3 der in Fig. 2 gezeigte Raum 27, der mit Elektrolyt gefüllt ist, abgeschlossen, so dass für das Metallisieren eines Mikrochipwafers 11 durch Elektrolyse ein vorbestimmtes Volumen an Elektrolyt zur Verfügung steht. Die für die Aufnahme von Elektrolyt vorgesehenen Räume 27 der Halteeinrichtungen 3 können voneinander unabhängig über Zuleitungen und die Ableitungen mit Elektrolyt gefüllt/entleert werden. Dies ergibt die in der Beschreibungseinleitung geschilderten Vorteile. Die Vorrichtungen, mit denen mehrere übereinander angeordnete Halteeinrichtungen 3 durch Verstellen der Klemmkörper 35 entlang der Führungsstäbe 41 aneinander gedrückt werden (Stellung gemäß Fig. 7), sind nicht dargestellt.

Um die Elektrolyse und damit das Metallisieren der Wafer zu unterstützen, insbesondere wenn die erfindungsgemäße Vorrichtung 1 mit dicht aneinander gelegten Halteeinrichtungen 3 gemäß Fig. 7 ("geschlossener Batch") verwendet wird, kann die Vorrichtung 1 insgesamt in Schwingungen versetzt werden, während die Elektrolyse ausgeführt wird. Hierzu ist im gezeigten Ausführungsbeispiel (Fig. 6 und 7) mit wenigstens einem der Führungsstäbe 41 ein Motor 43 mit Exzenter verbunden, so dass sich ein schwingender Elektrolytkörper ergibt. Die Frequenz kann fix oder gewählt-variabel oder zufällig-variabel eingestellt werden.

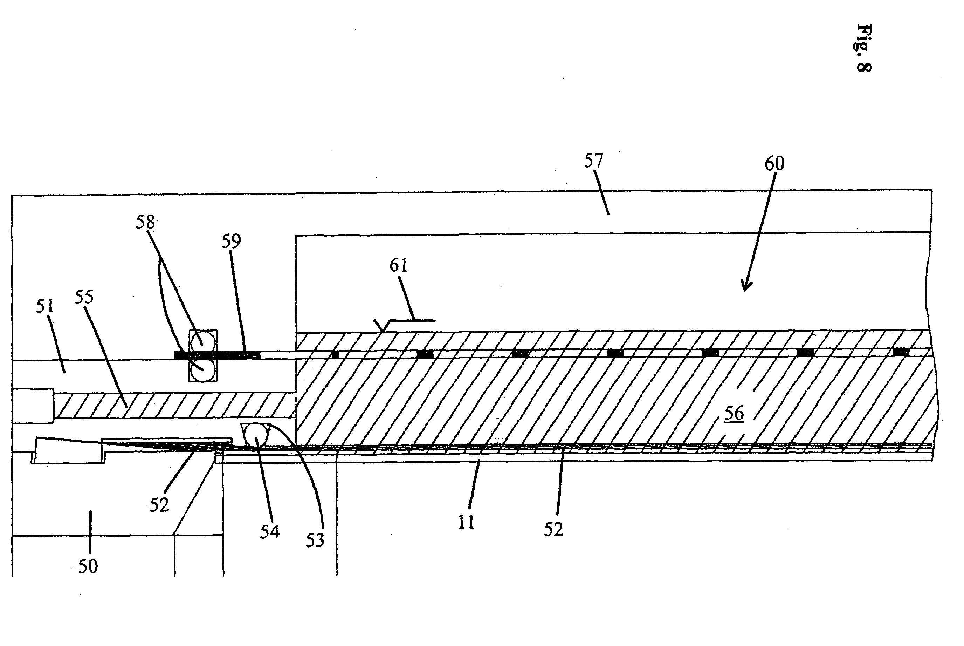

Bei der in Fig. 8 gezeigten Ausführungsform ist für jeden Wafer ein eigenes Modul, bestehend aus Abdeckung und Basisteil vorgesehen. Bei der in der Fig. 8 gezeigten Ausführungsform ist die Abdeckung nicht gleichzeitig die Basisplatte der darüberliegenden Waferhaltung. So stellt die in Fig. 8 gezeigte Ausführungsform einzelne Reaktormodule dar, die in Sequenz übereinander angeordnet werden, so dass eine Batch-Verfahrweise möglich ist.

Im Einzelnen ist die in Fig. 8 gezeigte Ausführungsform wie folgt aufgebaut:
Auf einem Basisteil 50 liegt ein Wafer 11 auf, dessen Vorderseite nach oben weist. Zwischen dem Basisteil 50 und dem Rahmenteil 51 ist ein Kontakt 52 angeordnet, der mit dem Rand des Wafers 11 elektrisch leitend in Berührung steht. Auf der dem Wafer 11 zugekehrten Seite des Rahmenteils 51 (nach unten zum Basisteil hin weisend) ist in einer Ringnut 53 eine Dichtung 54, insbesondere in Form eines O-ringes, aufgenommen.

Zusätzlich ist im Rahmenteil 51 wenigstens eine Leitung 55 vorgesehen, durch die Elektrolyt 56 in den Raum, in dem der Wafer 11 aufgenommen ist, in bzw. aus dem Raum abgeführt werden kann.

Auf dem Rahmenteil 51 sitzt die obere Abdeckung 57 (Deckplatte) auf, wobei zwischen der Deckplatte 57 und dem Rahmenteil 51 durch Ringdichtungen 58 (O-Ringe) gehalten eine gitterförmige Anode 59, insbesondere eine Anode 59 in Form eines Lochbleches oder Gitters, angeordnet ist.

Bei der in Fig. 8 gezeigten Ausführungsform wird in dem Raum oberhalb des Wafers 11 so viel Elektrolyt eingefüllt, dass die Anode 59 im Elektrolyt 56 untergetaucht ist, also der Elektrolytspiegel 61 oberhalb der Anode 59 liegt. Oberhalb des Elektrolytspiegels 61 ist in dem Raum zwischen Basisteil und Abdeckung ein Gasraum 60 vorgesehen, der mit einem inerten Gas, z.B. Stickstoff oder Argon oder einem anderen, bei den Verfahrensbedingungen inerten Gas, gefüllt ist.

Die erfindungsgemäßen Vorrichtungen, insbesondere die Vorrichtung von Fig. 8, erlauben, dass Elektrolyt während des Prozesses umgepumpt wird.

Grundsätzlich besteht die Möglichkeit, Elektrolyt mit einem inerten Gas außerhalb des Reaktors vor dem Füllen des Reaktors bzw. wenn Elektrolyt während des Prozesses umgepumpt wird, auch während des Prozesses zu Entgasen.

Wie bereits im Zusammenhang mit Fig. 8 angedeutet, ist der Gasraum oberhalb des Elektrolyten mit einem inerten Gas gefüllt, so dass während des Prozesses Inertgas vorliegt.

Das Spülwasser, das nach Beendigung der Behandlung des Wafers 11 angewendet wird, kann mit einem inerten Gas entgast werden, bevor es verwendet wird.

Nach dem Abschluss des Verfahrens kann noch folgende Prozesssequenz angewendet werden:
- Drainage des Elektrolyten aus der Prozesskammer durch Absaugen bzw. Herausdrücken durch Erhöhen des Druckes des inerten Gases im Gasraum,
- Trocknen der Prozesskammer und des in ihr enthaltenen Wafers mit inertem Gas,
- Entladen des Wafers nach dem Trocknen,
- Spülen des Wafers mit Wasser außerhalb der Prozesskammer,
- Abschließendes (erneutes) Trocknen des Wafers außerhalb der Prozesskammer.

Zusammenfassend kann ein Ausführungsbeispiel der Erfindung wie folgt beschrieben werden:
Eine Vorrichtung 1 zum Metallisieren von Wafern 11, insbesondere Mikrochipwafern, in einem Elektrolyt besteht aus mehreren Halteeinrichtungen 3, wobei jede Halteeinrichtung 3 einen Raum 27 für den Elektrolyt aufweist, der von den Aufnahmeräumen 27 für Elektrolyt in anderen Halteeinrichtungen 3 getrennt ist, und wobei jedem Wafer 11 ein als Kathode dienender Ring 15 und ein Anodennetz 29 als Anode zugeordnet ist.

## Patentansprüche

1. Vorrichtung (1) zum elektrolytischen Metallisieren von Wafern, insbesondere Mikrochipwafern (11), in einem Elektrolyt, insbesondere um Kanäle in Mikrochipwafern mit Metall, insbesondere Kupfer, zu füllen, mit einem Raum (27) für die Aufnahme des Elektrolyt, mit einer Anode (29), mit einem Kontakt (15), um den zu metallisierenden Wafer (11) als Kathode zu polen, wobei wenigstens eine Halteeinrichtung (3) für den zu metallisierenden Wafer (11) vorgesehen ist, **dadurch gekennzeichnet, dass** die Halteeinrichtung (3) aufweist
- eine Basisplatte (5) aus elektrisch isolierendem Werkstoff mit einem Aufnahmebereich (9) für den Wafer (11),
- einen Rahmen (21) aus isolierendem Werkstoff mit einer Aussparung (23), die den Raum (27) für Elektrolyt bildet,
- einen als Kathode dienenden Ring (15) aus elektrisch leitendem Werkstoff,
- eine auf der von der Basisplatte (5) abgekehrten Seite des Rahmens (21) angeordnete, den Raum (27) für Elektrolyt abdeckende Abschlussplatte und
- ein Anodennetz (29), das auf der dem Wafer (11) zugekehrten Seite der Abschlussplatte angeordnet ist, und
- dass Einrichtungen (35) zum Aneinanderdrücken von Basisplatte (5) und Rahmen (21) vorgesehen sind.

2. Vorrichtung nach Anspruch 1, **dadurch gekennzeichnet, dass** übereinander mehrere Halteeinrichtungen (3) vorgesehen sind und dass die Basisplatte (5) einer oberhalb angeordneten Halteeinrichtung (3) die Abschlussplatte der jeweils unterhalb angeordneten Halteeinrichtung (3) bildet.

3. Vorrichtung nach Anspruch 1 oder 2, **dadurch gekennzeichnet, dass** an der Basisplatte (5) und an dem Rahmen (21) nach außen weisende, vorzugsweise keilförmige, Vorsprünge (33) vorgesehen sind, an welchen die Einrichtungen (35) zum Aneinanderdrücken von Basisplatte (5) und Rahmen (21) angreifen, dass die Einrichtungen Klemmkörper (35) sind, die Nuten (37, 39) aufweisen, in welche die Vorsprünge (33) an der Basisplatte (5) und am Rahmen (21) eingreifen, dass sich die Nuten (37) Y-förmig in zwei Äste (39) teilen und dass die Klemmkörper (35) an Führungsstäben (41) senkrecht zur Ebene von Basisplatte (5) und Rahmen (21) verschiebbar geführt sind, dass Anordnungen aus einer Basisplatte (5) und einem Rahmen (21) aus einer Stellung, in der sie Abstand voneinander haben, in eine Stellung, in der sie aneinander anliegen, verstellbar sind und dass die Klemmkörper (35) zum Bewegen von Basisplatte (5) und Rahmen (21) aufeinander zu bzw. voneinander weg parallel zur Ebene des Rahmens (21) bzw. der Basisplatte (5) verstellbar sind.

4. Vorrichtung nach einem der Ansprüche 1 bis 3, **dadurch gekennzeichnet, dass** der Halteeinrichtung (3) bzw. den Halteeinrichtungen (3) wenigstens ein Schwingungserzeuger (43) zugeordnet ist.

5. Vorrichtung nach Anspruch 4, **dadurch gekennzeichnet, dass** der Schwingungserzeuger (43) ein Schwingungserzeuger zum Erzeugen von Schwingungen mit fixer, gewählt-variabler oder zufällig-variabler Frequenz ist.

6. Vorrichtung nach einem der Ansprüche 1 bis 5, **dadurch gekennzeichnet, dass** die Halteeinrichtung (3) temperierbar ist.

7. Vorrichtung nach einem der Ansprüche 1 bis 6, **dadurch gekennzeichnet, dass** bei mehreren Halteeinrichtungen (3) die geschlossenen Räume (27) für Elektrolyt unabhängig voneinander mit Elektrolyt füll- und entleerbar sind.

8. Vorrichtung nach einem der Ansprüche 1 bis 7, **dadurch gekennzeichnet, dass** das Anodennetz zur Mitte hin zunehmend enger gewebt ist.

9. Vorrichtung nach einem der Ansprüche 1 bis 8, **dadurch gekennzeichnet, dass** die vom Wafer (11) abgekehrte Fläche der Basisplatte (5) konvex gewölbt ist.

10. Vorrichtung nach einem der Ansprüche 1 bis 9, **dadurch gekennzeichnet, dass** in dem Raum für die Aufnahme von Elektrolyt (56) über dem Elektrolyt (56) ein Gasraum (60) vorgesehen ist und dass der Gasraum (60) vorzugsweise mit einem inerten Gas, insbesondere mit Stickstoff oder Argon, gefüllt ist.

11. Vorrichtung nach einem der Ansprüche 1 bis 10, **dadurch gekennzeichnet, dass** Leitungen vorgesehen sind und dass den Leitungen wenigstens eine Pumpe für das Umpumpen von Elektrolyt (56) im Kreislauf während des Betriebes der Vorrichtung zugeordnet ist.

12. Vorrichtung nach einem der Ansprüche 1 bis 11, **dadurch gekennzeichnet, dass** der Vorrichtung eine Einrichtung zum Entgasen von Elektrolyt (56) während des Betriebes der Vorrichtung zugeordnet ist.

13. Verfahren zum elektrolytischen Metallisieren von Wafern, insbesondere Mikrochipwafern, in einem Elektrolyt, bevorzugt unter Verwendung einer Vorrichtung nach einem der Ansprüche 1 bis 12, **dadurch gekennzeichnet, dass** der Elektrolyt vor dem Ausführen des Metallisierens oder während des Prozesses mit einem inerten Gas entgast wird.

14. Verfahren nach Anspruch 13, **dadurch gekennzeichnet, dass** der Elektrolyt innerhalb oder außerhalb der Vorrichtung entgast wird.

15. Verfahren zum elektrolytischen Metallisieren von Wafern, insbesondere Mikrochipwafern, in einem Elektrolyt, bevorzugt unter Verwendung einer Vorrichtung nach einem der Ansprüche 1 bis 12, **dadurch gekennzeichnet, dass** Spülwasser vor dem Ausführen des Spülens des Wafers nach Abschluss des Metallisierens entgast wird.

16. Verfahren zum elektrolytischen Metallisieren von Wafern, insbesondere von Mikrochipwafern, in einem Elektrolyt, bevorzugt unter Verwendung einer Vorrichtung nach einem der Ansprüche 1 bis 12, **dadurch gekennzeichnet, dass** der Elektrolyt entfernt wird und dass die Vorrichtung, insbesondere ihr den Elektrolyt und den Wafer aufnehmender Raum, noch vor dem Entladen des Wafers, insbesondere unter Verwenden von inertem Gas, getrocknet wird.

## Claims

1. Device (1) for the electrolytic metalization of wafers, in particular microchip wafers (11), in an electrolyte, in particular in order to fill channels in microchip wafers with metal, in particular copper, with a chamber (27) to receive the electrolyte, with an anode (29), with a contact (15) in order to polarize the wafer (11) to be metalized as cathode, whereby at least one holding arrangement (3) for the wafer (11) to be metalized is provided, **characterized in that** the holding arrangement (3) comprises
- a base plate (5) made of electrically insulating material with a receiving region (9) for the wafer (11),
- a frame (21) made of insulating material with a recess (23) which forms the chamber (27) for electrolyte,
- a ring (15) of electrically conducting material serving as cathode,
- a closure plate arranged on the side of the frame (21) facing away from the base plate (5) and covering the chamber (27) for electrolyte, and
- an anode network (29), which is arranged on the side of the closure plate that faces the wafer (11), and
- **in that** arrangements (35) are provided in order to hold the base plate (5) and the frame (21) in contact with each other.

2. Device according to claim 1, **characterized in that** a plurality of holding arrangements (3) are provided one above another, and **in that** the base plate (5) of a holding arrangement (3) arranged above forms the closure plate of the holding arrangement (3) respectively arranged underneath.

3. Device according to claim 1 or 2, **characterized in that** on the base plate (5) and on the frame (21) there are provided preferably wedge-like projections (33) that point outward, on which the arrangements (35) for pressing base plate (5) and frame (21) against one another act, that the arrangements are clamping elements (35), which have grooves (37, 39) into which the projections (33) on the base plate (5) and on the frame (21) engage, that the grooves (37) divide in a Y shape into two branches (39) and that the clamping elements (35) are guided such that they can be displaced on guide rods (41) at right angles to the plane of base plate (5) and frame (21), that arrangements comprising a base plate (5) and a frame (21) can be displaced from a position in which they are at a distance from each other into a position in which they rest on each other and that the clamping elements (35) for moving base plate (5) and frame (21) toward each other and away from each other can be displaced parallel to the plane of the frame (21) and the base plate (5) .

4. Device according to one of claims 1 to 3, **characterized in that** the holding arrangement (3) or the holding arrangements (3) is/are assigned at least one vibration generator (43).

5. Device according to claim 4, **characterized in that** the vibration generator (43) is a vibration generator for generating vibrations with a fixed, selectively variable or randomly variable frequency.

6. Device according to one of claims 1 to 5, **characterized in that** the temperature of the holding arrangement (3) can be controlled.

7. Device according to one of claims 1 to 6, **characterized in that**, in case of a plurality of holding arrangements (3), the closed chambers (27) for electrolyte can be filled with electrolyte and emptied independently of one another.

8. Device according to one of claims 1 to 7, **characterized in that** the anode network is woven increasingly more closely toward the middle.

9. Device according to one of claims 1 to 8, **characterized in that** the surface of the base plate (5) that faces away from the wafer (11) is curved convexly.

10. Device according to one of claims 1 to 9, **characterized in that** a gas chamber (60) is provided above the electrolyte (56) in the chamber for holding electrolyte (56) and that the gas chamber (60) is filled with an inert gas, in particular with nitrogen or argon.

11. Device according to one of claims 1 to 10, **characterized in that** conduits are provided and that the conduits are assigned at least one pump to pump electrolyte (56) around during the operation of the device.

12. Device according to one of claims 1 to 11, **characterized in that** the device is assigned an arrangement for venting electrolyte (56) during the operation of the device.

13. Method for the electrolytic metalization of wafers, in particular microchip wafers, in an electrolyte, preferably by using a device according to one of claims 1 to 12, **characterized in that** the electrolyte is vented with an inert gas before the metalization is carried out or during the process.

14. Method according to claim 13, **characterized in that** the electrolyte is vented inside or outside the device.

15. Method for the electrolytic metalization of wafers, in particular microchip wafers, in an electrolyte, preferably by using a device according to one of claims 1 to 12, **characterized in that** rinsing water is vented before the rinsing of the wafer following the conclusion of the metalization.

16. Method for the electrolytic metalization of wafers, in particular microchip wafers, in an electrolyte, preferably by using a device according to one of claims 1 to 12, **characterized in that** the electrolyte is removed and **in that** the device, in particular its chamber for holding the electrolyte and the wafer, is dried, in particular by using inert gas, before the unloading of the wafer.

## Revendications

1. Dispositif (1) pour la métallisation électrolytique de tranches, en particulier de tranches à micropuces (11), dans un électrolyte, en particulier pour remplir des canaux dans les tranches à micropuces avec du métal, en particulier du cuivre, avec un espace (27) pour la réception de l'électrolyte, avec une anode (29), avec un contact (15) pour polariser la tranche (11) à métalliser en tant que cathode, pour lequel au moins un dispositif de fixation (3) est prévu pour les tranches à métalliser (11), **caractérisé en ce que** le dispositif de fixation (3) comporte
- une plaque de base (5) en matériau électriquement isolant avec une zone de réception (9) pour la tranche (11),
- un cadre (21) en matériau isolant avec un évidement (23), qui forme l'espace (27) pour l'électrolyte,
- un anneau (15) servant de cathode dans un matériau électroconducteur,
- une plaque de fermeture recouvrant l'espace (27) pour l'électrolyte, disposée sur le côté du cadre (21) opposé à la plaque de base (5), et
- un réseau d'anodes (29) qui est disposé sur le côté de la plaque de fermeture tourné vers la tranche (11), et
- **en ce que** des systèmes (35) sont prévus pour comprimer l'un sur l'autre la plaque de base (5) et le cadre (21).

2. Dispositif selon la revendication 1 **caractérisé en ce que** plusieurs systèmes de fixation (3) l'un sur l'autre sont prévus et **en ce que** la plaque de base (5) d'un système de fixation (3) disposé au-dessus forme la plaque de fermeture du système de fixation (3) à chaque fois disposé en dessous.

3. Dispositif selon la revendication 1 ou 2 **caractérisé en ce que** sur la plaque de base (5) et sur le cadre (21) sont prévues des parties en saillie (33) pointant vers l'extérieur, de préférence cunéiformes sur lesquelles viennent en prise les systèmes (35) pour appuyer l'un contre l'autre la plaque de base (5) et le cadre (21), **en ce que** les systèmes sont des corps de serrage (35) qui comportent des rainures (37, 39) dans lesquelles viennent en prise les parties en saillie (33) sur la plaque de base (5) et sur le cadre (21), **en ce que** les rainures (37) se divisent en deux branches (39) en forme d'Y et **en ce que** les corps de serrage (35) sont guidés de manière mobile sur des barres de guidage (41) perpendiculairement au plan de la plaque de base (5) et du cadre (21), **en ce que** des montages composés d'une plaque de base (5) et d'un cadre (21) peuvent être réglés à partir d'une position dans laquelle ils sont à distance l'un de l'autre, dans une position dans laquelle ils sont placés l'un à côté de l'autre et **en ce que** les corps de serrage (35) peuvent être réglés pour déplacer la plaque de base (5) et le cadre (21) l'un sur l'autre ou éloignés l'un de l'autre parallèlement au plan du cadre (21) ou de la plaque de base (5).

4. Dispositif selon l'une quelconque des revendications 1 à 3 **caractérisé en ce qu'**au système de fixation (3) ou aux systèmes de fixation (3) est attribué au moins un oscillateur (43) .

5. Dispositif selon la revendication 4, **caractérisé en ce que** l'oscillateur (43) est un oscillateur destiné à produire des oscillations à une fréquence fixe, choisie variable ou par hasard variable.

6. Dispositif selon l'une quelconque des revendications 1 à 5, **caractérisé en ce que** le système de fixation (3) peut être tempéré.

7. Dispositif selon l'une quelconque des revendications 1 à 6, **caractérisé en ce que** pour plusieurs systèmes de fixation (3), les espaces fermés (27) pour l'électrolyte, peuvent être remplis et vidés d'électrolyte indépendamment l'un de l'autre.

8. Dispositif selon l'une quelconque des revendications 1 à 7, **caractérisé en ce que** le réseau anodique est tissé de plus en plus serré vers le milieu.

9. Dispositif selon l'une quelconque des revendications 1 à 8, **caractérisé en ce que** la surface de la plaque de base (5) opposée à la tranche (11) est bombée de façon convexe.

10. Dispositif selon l'une quelconque des revendications 1 à 9, **caractérisé en ce que** dans l'espace destiné à recevoir l'électrolyte (56) est prévu un compartiment de gaz (60) au-dessus de l'électrolyte (56) et **en ce que** le compartiment de gaz (60) est rempli de préférence d'un gaz inerte, en particulier d'azote ou d'argon.

11. Dispositif selon l'une quelconque des revendications 1 à 10, **caractérisé en ce que** des conduits sont prévus et **en ce qu'**aux conduits est attribuée au moins une pompe pour le transvasement de l'électrolyte (56) dans le circuit pendant le fonctionnement du dispositif.

12. Dispositif selon l'une quelconque des revendications 1 à 11, **caractérisé en ce qu'**au dispositif est attribué un système de dégazage de l'électrolyte (56) pendant le fonctionnement du dispositif.

13. Procédé de métallisation électrolytique de tranches, en particulier de tranches à micropuces, dans un électrolyte, de préférence en utilisant un dispositif selon l'une quelconque des revendications 1 à 12, **caractérisé en ce que** l'électrolyte est dégazé avec un gaz inerte avant l'exécution de la métallisation ou pendant le processus.

14. Procédé selon la revendication 13, **caractérisé en ce que** l'électrolyte est dégazé à l'intérieur ou à l'extérieur du dispositif.

15. Procédé de métallisation électrolytique de tranches, en particulier de tranches à micropuces, dans un électrolyte, de préférence en utilisant un dispositif selon l'une quelconque des revendications 1 à 12, **caractérisé en ce que** l'eau de rinçage est dégazée avant l'exécution du rinçage de la tranche après la fin de la métallisation.

16. Procédé de métallisation électrolytique de tranches, en particulier de tranches à micropuces, dans un électrolyte, de préférence en utilisant un dispositif selon l'une quelconque des revendications 1 à 12, **caractérisé en ce que** l'électrolyte est enlevé et **en ce que** le dispositif est séché, en particulier son espace recevant l'électrolyte et la tranche, encore avant le déchargement de la tranche, en particulier en utilisant du gaz inerte.
